# EUROPÄISCHE PATENTSCHRIFT

(11) **EP 0 478 815 B1**
(45) Veröffentlichungstag und Bekanntmachung des Hinweises auf die Patenterteilung: **16.06.1993**
(21) Anmeldenummer: 90118835.9
(22) Anmeldetag: 02.10.1990
(51) Int. Cl.: G01R 27/26

(54) **Materialfeuchtemessung**
Material humidity measurement
Mesure d'humidité d'un matériau

(43) Veröffentlichungstag der Anmeldung: 08.04.1992
(73) Patentinhaber: imko INTELLIGENTE MICROMODULE KÖHLER GmbH, D-76275 Ettlingen (DE)
(72) Erfinder: Köhler, Kurt, W-7505 Ettlingen 6 (DE); Fundinger, Robin, W-7516 Karlsbad (DE)
(74) Vertreter: Trappenberg, Hans

(56) Entgegenhaltungen:
- EP-A- 0 019 154
- EP-A- 0 288 099
- DE-A- 3 201 644
- GB-A- 2 045 442
- ELEKTOR, Band 7, Nr. 12, Dezember 1981, Seiten 12.18-12.19; "Capacitance meter module"
- Bulletin der bodenkundlichen Gesellschaft der Schweiz (1989), band 13, Seiten 117-122

## Beschreibung

Die Erfindung betrifft eine Einrichtung gemäß dem Oberbegriff des Anspruches 1

### Stand der Technik

Bekannt sind die folgenden Verfahren der Materialfeuchtemessung:

### Dörr- Wäge-Methode

Die thermische Trocknung einer Probe und der Schluß auf die Materialfeuchte aus dem Probengewicht vor und nach der Trocknung ist die klassische Feuchtigkeitsbestimmungsmethode und für viele Güter das Standardverfahren für Einzelbestimmungen. Die Automatisierung verlangt aber kontinuierlich funktionierende, verzögerungsarme Meßverfahren. Auch ist die notwendige Entnahme von Proben nachteilig.

### Calciumcarbid-Methode

Es gibt eine ganze Liste von chemischen Wasserbestimmungsmethoden. Bekannt ist z.B. die Methode, bei der eine Probe, etwa von Sand, in einem druckdichten Gefäß mit Calciumcarbid vermischt wird. Der Druck des entstehenden Azethylens ist dann ein Maß für die Sandnässe. Auch dieses Verfahren ist weder kontinuierlich, noch entspricht es der o.g. Aufgabenstellung, und es birgt den Nachteil der Probenentnahme.

### Karl-Fischer-Methode

Die Karl-Fischer-Methode, die eine jodometrische Reaktion ausnützt, ist die universellste der chemischen Wasserbestimmungsmethoden und gestattet, noch Wasserspuren von nur 0,1 mg im Lösungsmittelextrakt einer Probe zu bestimmen. Die einfach Anwendbarkeit vor Ort ist aber nicht gegeben.

### Elektrische Leitfähigkeitsmessung

Die elektrische Leitfähigkeitsmessung zur Materialfeuchtebestimmung nimmt einen bevorzugten Platz ein, weil sie apparativ einfach und preisgünstig, kontinuierlich messend und praktisch verzögerungsfrei ist. Der Meßbereich der Leitfähigkeitsmessung ist der hygroskopische Bereich der im trockenen Zustand elektrisch nichtleitenden Stoffe. Für sehr trockene Materialien ist die Leitfähigkeitsmessung wegen der hohen Meßwiderstände und für nasse Stoffe wegen des dort zu großen Elektrolyt-Einflusses nicht geeignet.

### Neutronenmessung

Neutronenstrahlen werden von den leichten Wasserstoffatomen stark abgebremst, während sie die meisten schwereren Elemente mühelos durchdringen können. Je nach Wassergehalt oder, genauer je nach Gehalt des Meßgutes an Wasserstoffatomen, wird ein mehr oder weniger großer Teil der ausgestrahlten schnellen Netronen gestreut und abgebremst. Das Zählrohr oder ein Szintillationszähler erfaßt einen repräsentativen Teil der so entstandenen langsamen Neutronen und bildet in Form einer Impulsrate mit einer Zeitkonstante von der Größenordung 1 Minute das Maß für den Wassergehalt, auf das Volumen bezogen. Als sehr vorteilhaft gilt dabei die Meßwertintegration über ein großes Meßgutvolumen. Nicht brauchbar ist die Methode bei Materialien, die noch schwankende stoffgebundene Wasserstoffgehalte aufweisen. Nachteilig ist besonders die Verwendung eines Neutronenstrahlers.

### Dielektrische Messung

Im Gegensatz zur Leitfähigkeitsmessung ist diese auch für Flüssigkeiten, für sehr trockene und auch für nasse Stoffe geeignet. Im Gegensatz zur Leitfähigkeitsmessung erfaßt sie auch in außen isolierte Teile eingeschlossene Feuchtigkeit und mittelt den Wassergehalt, während bei der Messung über breite Bahnen die Leitfähigkeitsmessung die nassen Nester anzeigt. Wenn eine entsprechende Meßleistung vorhanden ist, kann man dielektrisch auch weit hinein in den Naßbereich messen.

Da die hier zur schützende Erfindung eine Form der dielektrischen Messung ist, wird im weiteren detailliert auf den Stand dieser Technik eingegangen.

Grundsätzlich besteht ein monotoner eindeutiger Zusammenhang zwischen der Dielektrizitätskonstante ε des Mediums und dessen Feuchtigkeitsgehalt. So reduziert sich das Problem auf die Messung der Dielektrizitätskonstante ε. Hier haben sich in dem hier gegebenen Zusammenhang zwei Verfahren herausgebildet:
- Die Kondensatormethode, bei der zwei Platten in definierter räumlicher Anordnung benutzt werden, um über die Kapazität der Anordnung die Dielektrizitätskonstante zu messen. Hierbei treten entweder meßtechnische Probleme oder hinderliche Größen der Kondensatorplatten auf.
- Die Echomethode. Hier bilden Leiter eine endlich lange offene Leitung bekannter Geometrie. An dem elektrischen Anschluß wird ein kurzer Impuls eingeleitet, dessen Dauer kleiner ist als die Zeit, die bis zur Rückkehr des Echos von dem Ende der Leitung ist. Wird die Leitung in Form zweier paralleler Spieße ausgebildet, die in das Meßgut gesteckt werden, kann man aus der Laufzeit des Echos auf die Dielektrizitätskonstante des Mediums und weiter auf den Wassergehalt schließen. Schwierigkeiten dieses Verfahrens liegen in der kurzen Zeit vom Anlegen eines Signals bis zum Eintreffen des Echos (ca. 10 ns), weshalb noch erheblich kürzere Anregungsimpulse zu erzeugen sind, und in der Notwendigkeit, die Zeit von der Erzeugung des Impulses bis zu dessen Echo in genügend viele Inkremente aufzulösen, die in Größenordnungen um 1/100 ns kommen. Bekannte Geräte nehmen die Spannung am Eingang der Leitung als Transienten auf (z. Teil Sampling-Verfahren) und werten den Spannungsverlauf manuell oder automatisch aus. Hieraus ergibt sich ein erheblicher gerätetechnischer Aufwand, insbesondere wegen der nötigen Kürze und der präzisen Wiederholbarkeit der Signale und deren periodische Folge, die wegen des Aufnahme-Verfahrens erforderlich ist.

Eine derartige dielektrische Messung gemäß der Echomethode, die auch dem Oberbegriff des Anspruchs 1 bildet, ist bekannt aus dem Bulletin der bodenkundlichen Gesellschaft der Schweiz, Band 13 (1989), Seiten 117-122.

### Aufgabe der Erfindung

Aufgabe der Erfindung ist es, einen Materialfeuchtesensor zu entwickeln, der gegenüber den bekannten Ausführungen Vorteile bietet, durch eine preisgünstige Realisierung mit üblichen elektronischen Schaltelementen bei geringem Aufwand, der aber trotzdem eine hohe Meßgenauigkeit und automatische Materialfeuchtebestimmung ergibt, wobei nur ein Abgleich bei der Herstellung notwendig ist.

Erfindungsgemäß wird dies durch die Einrichtung nach Anspruch 1 erreicht. Vorteilhafte Ausgestaltungen der Einrichtung sind in den Unteransprüchen gekennzeichnet. Besonders vorteilhaft ist die leichte Auswertbarkeit und Abgleichfreiheit sowie der Verzicht und Probenentnahme.

### Ausführungsbeispiel

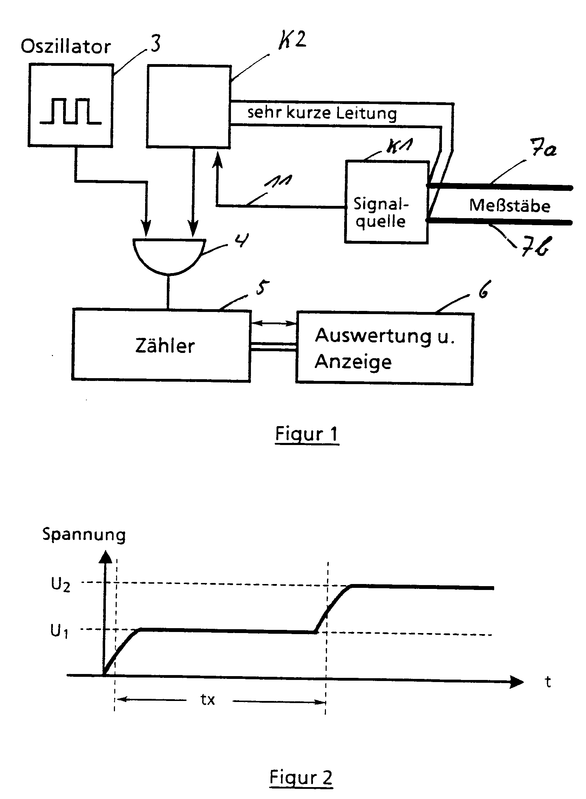

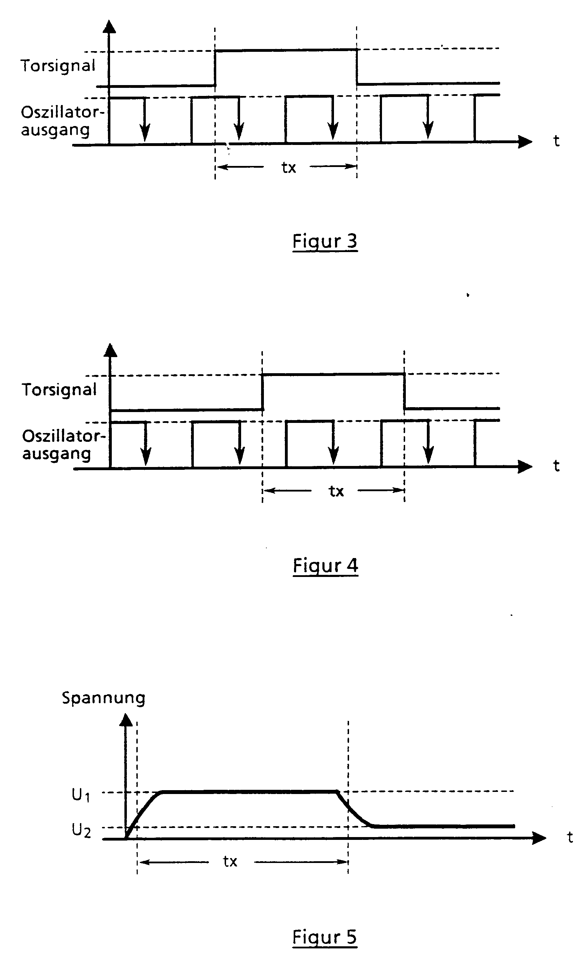

Weitere Einzelheiten ergeben sich aus einem Ausführungsbeispiel nach Figur 1.

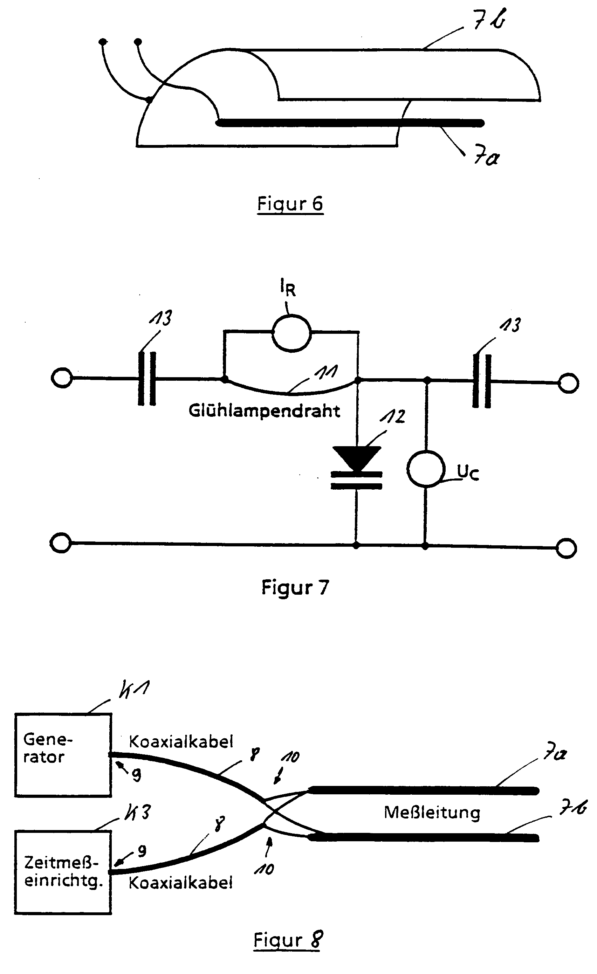

Auf einer am Ende offenen Meßleitung 7a, 7b, bestehend aus zwei parallelen Meßstäben, wird ein Spannungsanstieg mit möglichst steiler Signalflanke durch eine Signalquelle K1 erzeugt, die mit vernachlässigbarer Länge der Zuleitung angeschlossen ist. Der Innenwiderstand der Signalquelle K1 entspricht dem Wellenwiderstand der offenen Leitung 7a, 7b, soweit dieser mit einfachen Mitteln für die Mitte des Meßbereiches nachbildbar ist. Auf diese Weise entstehen an der Verbindung zwischen dem Ausgang von K1 und der Meßleitung 7a, 7b bei geeignetem Meßbereich wenig störende Reflexionen. An deren offenem Ende tritt jedoch volle Reflexion auf. Das Echo erreicht den Anfang der Leitung nach einer Zeit tx (Fig. 2), die abhängig von den durch Feuchte des Dielektrikums beeinflußten physikalischen Daten der Leitung 7a, 7b ist. Durch den Schwellwertschalter K2, der die Spannung am elektrischen Anschluß der Meßstäbe mit vorgegebenen Werten vergleicht, wird ein Torsignal für einen Zähler 5 erzeugt, der nur in der Zeit zwischen Beginn der Erregung und Eintreffen des Echos Impulse eines frei laufenden Oszillators 3 zählt. Der Zähler 5 ist seinerseits mit einer Auswerte- und Anzeigeeinrichtung 6 verbunden. Der Beginn der Toröffnung kann vorteilhaft auch durch die Signalquelle K1 verzögert eingeleitet werden, so daß eine Öffnung erst erfolgt, nachdem die Reflexion am Anschluß der Meßstäbe vorüber ist.

Durch die Variation der Materialfeuchte ändert sich die Dielektrizitätskonstante und damit der Kapazitätsbelag des Mediums, das die Stäbe der Meßleitung 7a, 7b umgibt. Nachdem die geometrischen Daten der Meßleitung 7a, 7b konstant sind, folgt daraus ein bekannter Zusammenhang zwischen Materialfeuchte und gemessener Laufzeit tx des Echos. Dieser kann durch eine Gleichung oder eine Eichkurve gegeben sein. Im folgenden wird die Messung von tx als wesentlicher Bestandteil der Einrichtung beschrieben:

Eine der durch die Erfindung gegebenen Verbesserungen gegenüber den bekannten Einrichtungen liegt in der Verwendung impulsförmiger anregender Signale, die nicht kürzer als die Laufzeit des Echos sind. Am Eingang der Meßleitung 7a, 7b überlagern sich Anregung und Echo zu einem gesamten Spannungsverlauf wie Figur 2 zeigt.

Dort findet zu Beginn der Anregung zunächst eine Erhöhung der Spannung vom Ruhewert (hier Null) auf U₁ statt. U₁ ergibt sich aus der Leerlaufspannung der Signalquelle K1 und dem Teilerverhältnis, das sich aus der Leitungsanpassung Ri (Innenwiderstand der Signalquelle) und dem Wellenwiderstand ergibt. Bei Eintreffen des Echos steigt die Spannung auf U₂. Die Erhöhung U₂-U₁ wird durch den Reflexionsfaktor der Leitung bestimmt, der nahezu 1 ist. Danach klingen die transienten Vorgänge auf der Leitung 7a, 7b ab. Aber gleichzeitig belastet der Wellenwiderstand die Signalquelle K1 nicht mehr, und die Leerlaufspannung der Signalquellle K1 wird erreicht.

Der Vorteil eines Eingangssignals, bei dem Vorder- und Rückflanke, gemessen an tx, zeitlich weit auseinanderliegen, liegt in der weniger aufwendigen elektronischen Realisierung:

Es kann eine Endstufe verwendet werden, die zur Erzeugung einer steilen Flanke bis in die Sättigung gesteuert wird, was Speicherzeiten zur Folge hat, die eine Impulsdauer kleiner als die Zeit tx schwierig machen. In der hier beschriebenen Ausgestaltung stört die Speicherzeit nicht. Als Massenprodukt verfügbare Schaltelemente sind verwendbar. Trotzdem bleibt die Notwendigkeit, die Zeit tx mit einer Auflösung von 10ps zu bestimmen. Um dieses ebenfalls mit einfachen elektronischen Mitteln automatisch auszuführen, wird in erfinderischer Weise auf statistische Methoden zurückgegriffen, wie im folgenden beschrieben.

Während der Laufzeit des Echos tx wird durch eine geeignete Schaltung K2 ein Torsignal erzeugt, wobei der Beginn aus der Signalquelle K1 abgeleitet und das Ende durch einen Schwellschalter gegeben wird, der das Eintreffen des Echos an der Spannungserhöhung über einen Schwellwert zwischen U₁ und U₂ erkennt. Weiterhin ist ein Oszillator 3 vorhanden, der frei läuft und dessen Periodendauer so eingestellt ist, daß nur wenige seiner Perioden in die Zeit tx fallen. Er erzeugt den Meßtakt.

Während der Zeit tx wird das Tor 4 geöffnet, das die von dem Oszillator 3 erzeugte Schwingung mit einem Zähler 5 verbindet, der jeweils die Anzahl der in tx auftretenden negativen Flanken des Oszillators 3 zählt (die positiven bzw. positive und negative Flanken könnten auch gezählt werden). Figur 3 zeigt ein Beispiel, bei dem der zeitliche Zusammenhang zwischen Torsignal und Oszillatorsignal zur Zählung zweier negativer Flanken des Oszillatorsignals führt.

Figur 4 zeigt dasselbe in einem anderen zeitlichen Zusammenhang zwischen Torsignal und Meßtakt, der nur zur Zählung einer Flanke führt.

Da keine Anbindung der Phase des Oszillators 3 an den Meßvorgang stattfindet, sind alle Zwischenstufen möglich. Deshalb ist die Wahrscheinlichkeit, mit der zwei negative Flanken des Oszillatorsignals innerhalb tx (wie in Figur 3) gezählt werden, in diesem Fall 0,5. Die Wahrscheinlichkeit, daß nur eine Flanke (wie in Figur 4) gezählt wird, ist hier ebenfalls 0,5. Da in diesem Beispiel beide Fälle gleich häufig auftreten, werden bei einer Toröffnung im Mittel 1,5 Flanken gezählt. Werden nun die Flanken z. B. über 1000 Öffnungen des Tores 4 gezählt, ist die Zahl 1500 als Ergebnis für tx mit geringer Streuung zu erwarten.

Allgemein nimmt mit tx das erwartete Zahlenergebnis proportional zu. Wird die Messung genügend oft wiederholt, kann das Zählergebnis und damit die Dauer von tx mit so guter Auflösung bestimmt werden, daß auf die Zeit tx mit einer Auflösung von 10ps geschlossen werden kann. Das sich für diese Messung ergebende Vertrauensintervall ist gegeben durch Gesetze der Statistik, angewandt auf vorstehende Überlegung und Schwankungen in der Funktion der Tor- und Zählschaltung, soweit sie normal verteilt sind und nicht ihre Ursache in Driften oder Schwankungen haben, die über die Zeit zur Ermittlung des Meßergebnisses hinausgehen.

Somit sind nur im Mittel konstante Frequenz des Oszillators 3 sowie konstante oder kompensierbare Verzögerungszeiten der logischen Schaltelemente erforderlich, nicht aber Jitterfreiheit, Rauschfreiheit oder die Verarbeitung von Frequenzen über 500 MHz. Es ergibt sich bei dieser Lösung auch eine gute Integrierbarkeit in vorgefertigte Kundenschaltungen (ASIC), die einen Zuwachs an Reproduzierbarkeit und Schnelligkeit mit sich bringt. Auch ergibt sich so eine billigere Lösung.

Die Mittelwertbildung der Meßergebnisse geschieht hier durch das Aufsummieren der Zählergebnisse mit einer Zählerkette. Varianten zu diesem Ausführungsbeispiel sind möglich und werden im folgenden beschrieben.

### Ausführungsvarianten

Eine mögliche Ausgestaltung der Einrichtung ist auch durch Sensoren mit einem Ausgang gegeben, der die Zählergebnisse zum Abruf durch einen angeschlossenen Rechner bereithält, der die Berechnung und Anzeige der Materialfeuchte ausführt. Auch mehrere Sensoren können an einen Rechner angeschlossen werden.

Vorteilhaft ist auch eine Variante, bei der der Zähler 5 vor der nötigen Anzahl von Toröffnungen so oft wie möglich ausgelesen wird und die Aufsummierung zu einer Zahl, die eine Meßwertbestimmung mit genügender Auflösung und Genauigkeit ermöglicht, in einer weiteren Einrichtung z. B. einem Rechner erfolgt. Sind z. B. 1000 Öffnungen des Tores 4 nötig, und wird beispielsweise nach jeder 20ten Öffnung ein Zwischenwert erfaßt und gespeichert, ergibt sich das zu ermittelnde Zahlenergebnis durch Addition der 50 Einzelwerte. Weiterhin sind mit Hilfe der Einzelwerte aber auch Aussagen z. B. über die Streuung der einzelnen erfaßten Zahlen möglich, die zu einer statistischen Bewertung der Messung führen. Rückschlüsse über das Vertrauensintervall und über eventuelle vorübergehende, die Messung verfälschende Störungen sind so möglich.

Weitere Ausführungsbeispiele betreffen die Ausführung der Meßleitung 7a, 7b. Diese kann für Erde und Schüttgüter als parallele Spieße erfolgen, aber für die Messung an Materialien, die nur berührt werden können oder dürfen (Beton, Platten, nicht zu verletztende Oberflächen), auch als aufgelegte parallele Leitung. Dabei muß bei der Ermittlung der Materialfeuchte berücksichtigt werden, daß dann ein längs der Leitung geteiltes Dielektrikum vorliegt, das zur Hälfte aus Luft besteht. Durch diese Ausführung wird die Anwendung im gesamten Bau- und Holzsektor erleichtert.

In einem weiteren Ausführungsbeispiel wird die Meßleitung 7a, 7b nicht als offene sondern als am Ende kurzgeschlossene Leitung ausgeführt. Gegenüber der offenen Leitung kehrt sich hier die Polarität des Echos um. Es ergibt sich ein Spannungsverlauf am Eingang der Leitung 7a, 7b wie in Figur 5 gezeigt.

Hier ergeben sich Vorteile bei der Bestimmung der Laufzeit tx. Eine Schaltung K2, die aus einem Schwellschalter mit einer Schwelle zwischen U₁ und U₂ besteht, kann hier leicht das Torsignal für die Zähler 5 erzeugen. Eine Ableitung des Beginnzeitpunktes für die Toröffnung aus der Signalquelle K1 ist nicht nötig, kann aber auch vorteilhaft sein, um Unabhängigkeit von Effekten kurz nach der Erregung zu erreichen.

Weitere Ausführungsvarianten ergeben sich durch die Gestaltung der Meßleitung 7a, 7b. Diese kann auch aus mehreren zusammengeschalteten Einzelleitern bestehen, so daß die elektromagnetische Welle eine gewünschte definierte Ausbreitung in der Probe annimmt. Vorteilhaft ist auch, einen 7b der Leiter 7a, 7b so auszuführen, daß er den oder die anderen 7a umhüllt und Fremdfelder abschirmt.

Insbesondere bei der Materialfeuchtemessung an festem Gut durch Auflegen eines paralleln Leiterpaares als Meßleitung ist die Dielektrizitätskonstante des offenen Halbraumes nicht definiert. Durch gleichzeitiges Auflegen einer Hand z.B. wird das Meßergebnis unbrauchbar. Eine Gestaltung nach Figur 6 bringt hier Abhilfe.

Die Gestalt der Meßleitung entspricht einer längs der Mittelachse geteilten Koaxialleitung. Mittelleiter und die Längskanten des Außenleiters bilden eine Ebene zur Auflage auf dem Meßgut. Der Zwischenraum zwischen Innenleiter 7a und Außenleiter 7b wird durch ein Dielektrikum mit konstanten Eigenschaften, Luft oder einem Feststoff, gebildet. Der Außenleiter 7b kann als Griff dienen. Auch hier kann die Leitung am Ende offen oder kurzgeschlossen sein. Erfahrungsgemäß ergibt sich hier kein linearer Zusammenhang zwischen tx und Materialfeuchte.

Eine weitere Variante dient dazu, Reflexionen am Beginn der Meßleitung kleinzuhalten. Wird nämlich ein Meßbereich beispielsweise von trockenem Sand bis zum wassergesättigten Erdboden verlangt, kann der Wellenwiderstand sich um den Faktor 7 ändern, so daß eine Anpassung des Innenwiderstandes an die Meßleitung 7a, 7b nicht mehr gegeben ist. Kann das Echo vom Ende der Meßleitung (sei dieses offen oder kurzgeschlossen) wegen der Reflexion am Anfang nicht mehr durch Schwellentscheid erkannt werden, liegt der dadurch vorgetäuschte Meßwert außerhalb des Meßbereiches. Durch Zwischenschaltung eines steuerbaren Impedanzanpassers zwischen Ausgang des Generators K1 mit niedrigem Innenwiderstand und Eingang der Meßleitung 7a, 7b wird Abhilfe geschaffen. Die Einstellung des Impedanzanpassers wird, manuell oder durch einen Auswerterechner gesteuert, so lange verändert, bis ein plausibler Meßwert registriert wird. Unter Verwendung der Eingangsimpedanz der Meßleitung, die sich aus der so gemessenen Zeit tx ergibt (rechnerisch oder aufgrund einer experimentell ermittelten Tabelle), wird die Einstellung des Impedanzanpassers so verändert, daß eine möglichst gute Anpassung erreicht wird. Sodann wird erneut gemessen und hierdurch ein genauer Meßwert erreicht. Der Impedanzanpasser läßt sich beispielsweise nach Figur 7 realisieren.

Im Längszweig befindet sich der Hitzdraht 11 einer Miniaturglühlampe, dessen Widerstand von der Stromquelle I_{R} gesteuert wird. Im Querzweig befindet sich eine Kapazitätsdiode 12, die durch die Spannungsquelle U_{c} gesteuert wird. Die Spannungsquelle U_{c} enthält einen hohen induktiven Innenwiderstand, der ein Abfließen des Signals weitgehend unterbindet. Zwei Kondensatoren 13 im Längspfad dienen zur Entkopplung.

Eine weitere Variante ist vorteilhaft, wenn elektronische Schaltungen und deren umgebendes Gehaüse am Anfang der Meßleitung 7a, 7b die Probe beeinflussen; wenn diese Elemente z.B. den zu messenden Erdboden vom Regen abschirmen. Hier erfolgt der Anschluß des Generators K1 und der Zeitmeßeinrichtung K3 über Leitungen 8, die so lang sind, daß ihr Wellenwiderstand, den sie am Ausgang des Generators K1 bzw. am Eingang der Zeitmeßschaltung K3 repräsentieren, von der Impedanz der Meßleitung 7a, 7b kaum noch beeinflußt wird, so daß der Anschluß am Generator sowie der an der Zeitmeßschaltung angepaßt und reflexionsarm gestaltet werden kann. Figur 8 zeigt die Schaltung.

Das Signal des Generators K1 gelangt nun einerseits direkt auf den Weg über den Anschluß an der Meßleitung 7a, 7b, andererseits um die Echozeit tx verspätet zur Zeitmeßeinrichtung K3. Das direkte Signal wird dazu benutzt, eine Torschaltung wie im ersten Ausführungsbeispiel zu öffnen; das nach Reflexion am Ende der Meßleitung empfangene Signal wird benutzt, um das Tor wieder zu schließen. Auf diese Weise gelingt die Messung von tx wie im ersten Ausführungsbeispiel.

Eine weitere Variante betrifft die Umhüllung der Leiter der Meßleitung mit einer isolierenden Schicht bekannter bzw. durch Feuchte unveränderlicher Dielektrizitätkonstante. Hierdurch wird unerwünschter Stromfluß durch das zu messende Medium vermieden.

Eine weitere Variante betrifft die Torschaltung, bei der die Öffnung des Tores gesteuert durch den Generator erst erfolgt, wenn die Reflexion am Anfang der Meßleitung vorüber ist, bzw. nachdem die Erregung auf direktem Weg die Zeitmeßeinrichtung erreicht hat und somit nur die vom Ende der Meßleitung reflektierte Erregung einen Schwellwertschalter zum Schließen des Tores veranlassen kann.

## Patentansprüche

1. Einrichtung zur Ermittlung der Materialfeuchte eines Mediums durch Bestimmung dessen Dielektrizitätskonstante welches Medium das Dielektrikum einer Meßleitung (7a, 7b) bildet, mit Hilfe eines Signalgebers (K1), der ein pulsförmiges Signal in das eine Ende der Meßleitung (7a, 7b) einspeist und eines Empfängers (K2), der an demselben Ende das am anderen Ende der Meßleitung (7a, 7b) reflektierte Signal empfängt sowie einer Einrichtung (3, 4, 5) zum Messen der Zeit, die zwischen dem Beginn des Einspeisens des Signals und dem Eintreffen des reflektierten Signals verstreicht,
dadurch gekennzeichnet,
daß die Pulsdauer des einzuspeisenden Signals größer ist als die Zeit, die zwischen dem Beginn des Einspeisens des Signals und dem Eintreffen des reflektierten Signals verstreicht.

2. Einrichtung zur Ermittlung der Materialfeuchte nach Anspruch 1,
dadurch gekennzeichnet,
daß die Messung der Zeit zwischen Anlegen des Signals durch den Signalgeber (K1) und dem Eintreffen des reflektierten Signals mit einer Einrichtung (3, 4, 5) zum inkrementalen Messen einer Zeit erfolgt, und daß die Meßauflösung sowie die Meßgenauigkeit mit einer Einrichtung (6) zur Auswertung der Zählergebnisse erreicht wird durch automatische Mittelung über eine große Anzahl von Einzelmessungen.

3. Einrichtung zur Ermittlung der Materialfeuchte nach Anspruch 1 oder 2,
dadurch gekennzeichnet,
daß die Messung der Zeit zwischen dem Anlegen des Signals durch den Signalgeber (K1) und dem Eintreffen des reflektierten Signals, welches mit dem Empfänger (K2) registriert wird, durch einen Zähler (5) erfolgt, der über eine Torschaltung (4) mit einem frei laufenden Generator (3) verbunden ist, der eine feste Frequenz aufweist, deren Periodendauer kleiner ist als die zu erwartende kleinste Zeit zwischen Anlegen des Signals und dem Eintreffen des reflektierten Signals und größer ist als das gemäß einer geforderten Auflösung für die Messung der Zeit zwischen dem Anlegen des Signals und dem Eintreffen des reflektierten Signals, größte zulässige Zeitinkrement,
daß das Tor (4) jeweils in der Zeit zwischen Anlegen des Signals an die Meßleitung und Eintreffen des am Ende der Meßleitung reflektierten Signals geöffnet ist,
daß der Zähler (5) durch den Generator (3) erzeugte Ereignisse genau dann aufsummiert, wenn das Tor (4) geöffnet ist,
daß das Ergebnis des Zählvorgangs erst dann in der Einrichtung (6) zur Auswertung der Zählergebnisse ausgewertet wird, wenn eine Anzahl von Toröffnungen erreicht ist, nach der sich ein Zählergebnis mit vorbestimmter Auflösung ergibt,
daß der Zähler (5) erst dann zurückgesetzt wird, wenn das Ergebnis des Zählvorganges ausgelesen wurde, und daß das Ergebnis des Zählvorgangs in der Einrichtung (6) zur Auswertung der Zählergebnisse in eine Maßzahl für die Materialfeuchte mit Hilfe einer Formel oder einer empirischen Tabelle umgewandelt wird.

4. Einrichtung zur Ermittlung der Materialfeuchte nach Anspruch 1 oder 2,
dadurch gekennzeichnet,
daß die Messung der Zeit zwischen dem Anlegen des Signals durch den Signalgeber (K1) und dem Eintreffen des reflektierten Signals, welches mit dem Empfänger (K2) registriert wird, durch einen Zähler (5) erfolgt, der über eine Torschaltung (4) mit einem frei laufenden Generator (3) verbunden ist, der eine feste Frequenz aufweist, deren Periodendauer kleiner ist als die zu erwartende kleinste Zeit zwischen Anlegen eines Signals und dem Eintreffen des reflektierten Signals und größer ist als das gemäß einer geforderten Auflösung für die Messung der Zeit zwischen Anlegen des Signals und dem Eintreffen des reflektierten Signals größte noch zulässige Zeitinkrement,
daß jeweils das Zählergebnis als Teilergebnis in der Einrichtung (6) zur Auswertung der Zählergebnisse schon nach einer oder nach so wenigen Toröffnungen als Teilergebnis erfaßt wird, daß eine vorbestimmte, für das Meßergebnis geforderte Auflösung des Zählergebnisses noch nicht erreicht ist, wonach der Zähler zurückgesetzt wird,
daß nach der Erfassung einer vorbestimmten Anzahl von Teilergebnissen in der Einrichtung (6) zur Auswertung der Zählergebnisse der Mittelwert und die Streuung bestimmt werden, und
daß in der Einrichtung (6) zur Auswertung der Zählergebnisse aus dem Mittelwert eine Maßzahl für die Materialfeuchte mit Hilfe einer Formel oder einer empirischen Tabelle und aus der Streuung eine Zahl über dessen Vertrauensintervall erzeugt wird.

5. Einrichtung zur Ermittlung der Materialfeuchte nach einem der Ansprüche 1 bis 4,
dadurch gekennzeichnet,
daß die Meßleitung (7a, 7b) aus parallelen Stäben besteht.

6. Einrichtung zur Ermittlung der Materialfeuchte nach einem der Ansprüche 1 bis 5,
dadurch gekennzeichnet,
daß die Leiter der Meßleitung (7a, 7b) mit einem isolierenden Überzug konstanter Dielektrizitätskonstante versehen sind.

7. Einrichtung zur Ermittlung der Materialfeuchte nach einem der Ansprüche 1 bis 6,
dadurch gekennzeichnet,
daß einer der Leiter (7b) der Meßleitung den (7a) oder die anderen so umhüllt, daß außenliegende Felder abgeschirmt werden.

8. Einrichtung zur Ermittlung der Materialfeuchte nach einem der Ansprüche 1 bis 6,
dadurch gekennzeichnet,
daß die Leiter (7a, 7b) der Meßleitung so ausgebildet sind, daß sie auf der Oberfläche einer Probe mit nahezu ebener Oberfläche aufliegen können, so daß die Materialfeuchte in einer festen Probe gemessen werden kann, wobei zur rechnerischen Ermittlung der Materialfeuchte aus der Laufzeit des reflektierten Signals, welches mit dem Empfänger (K2) registriert wird, berücksichtigt wird, daß das Dielektrikum längs der Meßleitung geteilt ist und ein nichtlinearer Zusammenhang zwischen der Laufzeit des reflektierten Signals besteht.

9. Einrichtung zur Ermittlung der Materialfeuchte nach einem der Ansprüche 1 bis 8,
dadurch gekennzeichnet,
daß einer der Leiter (7b) der Meßleitung den (7a) oder die anderen so umhüllt, daß die Kanten des umhüllenden Leiters (7b) und der/die andere/n Leiter (7a) gleichzeitig auf der Oberfläche einer ebenen Probe aufliegen, so daß die Messung der Dieleketrizitätskonstante nicht von dem Bereich außerhalb des umhüllenden Leiters abhängig ist.

10. Einrichtung zur Ermittlung der Materialfeuchte nach Anspruch 9,
dadurch gekennzeichnet,
daß der Raum zwischen dem umhüllenden Leiter (7b) und der Ebene in der die Einrichtung auf der Probe aufliegt, mit einem Medium bestimmter Dielektrizitätskonstante ausgefüllt ist.

11. Einrichtung zur Ermittlung der Materialfeuchte nach einem der Ansprüche 1 bis 10,
dadurch gekennzeichnet,
daß sowohl der Signalgeber (K1) zum Anlegen des Signals an die Meßleitung (7a, 7b) als auch der Empfänger zum Registrieren des Eintreffens des reflektierten Signals mit der Meßleitung jeweils über Leitungen (8) verbunden sind, die so lang sind, daß der Wellenwiderstand an einem Ende (9) nur wenig von dem Abschluß an dem anderen Ende (10) abhängt, so daß ein angepaßter Abschluß zum Signalgeber (K1) und zur Zeitmeßschaltung auch bei stark unterschiedlichem Wellenwiderstand der Meßleitung selbst ermöglicht wird, und
daß die Zeit zwischen dem Anlegen des Signals durch den Signalgeber (K1) an die Meßleitung (7a, 7b) und dem Eintreffen des reflektierten Signals, welches mit dem Empfänger registriert wird, am einen Ende (9) der Meßleitung gemessen wird, indem eine Torschaltung geöffnet wird, wenn die Erregung über die Hintereinanderschaltung der Zuleitung vom Signalgeber (K1) zur Meßleitung und der Verbindung zwischen Meßleitung und Zeitmeßschaltung letztere erreicht, und geschlossen wird, wenn die am Ende der Meßleitung reflektierte Erregung die Zeitmeßschaltung erreicht.

12. Einrichtung zur Ermittlung der Materialfeuchte nach einem der Ansprüche 1 bis 11,
dadurch gekennzeichnet,
daß eine Vorrichtung vorgesehen ist, die die Torschaltung (4) erst dann öffnet, wenn etwaige Reflektionen am Anfang der Meßleitung (7a, 7b) vorüber sind beziehungsweise nachdem die über direkte Leitung eintreffende Erregung bereits eingetroffen ist.

13. Einrichtung zur Ermittlung der Materialfeuchte nach einem der Ansprüche 1 bis 12,
dadurch gekennzeichnet,
daß eine Schaltung vorgesehen ist, die als einstellbare Impedanz zwischen den dann mit niedriger Impedanz ausgestatteten Signalgeber (K1) und der Meßleitung (7a, 7b) geschaltet ist, wodurch eine Anpassung des Signalgeberinnenwiderstandes an den bei der jeweiligen Materialfeuchte vorhandenen Wellenwiderstand der Meßleitung (7a, 7b) vorgenommen wird, um Störungen durch Reflexion am Anfang der Meßleitung (7a, 7b) zu verkleinern.

14. Einrichtung zur Ermittlung der Materialfeuchte nach Anspruch 13,
dadurch gekennzeichnet,
daß eine Vorrichtung vorgesehen ist, die die Schaltung zur Anpassung der Impedanz automatisch derart einstellt, daß bei einem Meßergebnis, das als falsch erkannt wird, die Schaltung zur Anpassung der Impedanz solange verstellt wird, bis ein plausibles Ergebnis erreicht wird, das aus dem dann erreichten Meßergebnis auf den Wellenwiderstand der Meßleitung (7a, 7b) geschlossen wird und die Schaltung zur Anpassung der Impedanz so eingestellt wird, daß Anpassung erreicht wird, und daß danach eine erneute Messung erfolgt, deren Ergebnis zur Darstellung der Materialfeuchte dient.

15. Einrichtung zur Ermittlung der Materialfeuchte nach Anspruch 13 oder 14,
dadurch gekennzeichnet,
daß die zur Anpassung notwendigen Einstellwerte aus einer Tabelle entnommen werden, bei der auch die Temperatur berücksichtigt wird.

16. Einrichtung zur Ermittlung der Materialfeuchte nach einem der Ansprüche 13 bis 15,
dadurch gekennzeichnet,
daß ein Rechner mit Ausgabeschaltungen vorgesehen ist, mittels dem die Vorrichtung zur Anpassung der Impedanz automatisch einstellbar ist.

## Claims

1. Apparatus for ascertaining the material moisture content of a medium by determining its dielectric constant, which medium forms the dielectric of a measuring line (7a, 7b), by means of a signal transmitter (K1) which feeds a signal in pulse form into the one end of the measuring line (7a, 7b), and a receiver (K2) which receives at the same end the signal reflected at the other end of the measuring line (7a, 7b), and a device (3, 4, 5) for measuring the time which elapses between the beginning of the feed-in of the signal and the arrival of the reflected signal, characterised in that
the pulse duration of the signal to be fed in is greater than the time which elapses between the beginning of the feed-in of the signal and the arrival of the reflected signal.

2. Apparatus for ascertaining material moisture content according to claim 1, characterised in that
measurement of the time between the application of the signal by the signal transmitter (K1) and the arrival of the reflected signal is effected by a device (3, 4, 5) for the incremental measurement of a time and that measurement resolution and measurement accuracy is achieved with a device (6) for evaluation of the counter results by automatic averaging over a large number of individual measurements.

3. Apparatus for ascertaining material moisture content according to claim 1 or claim 2, characterised in that
measurement of the time between the application of the signal by the signal transmitter (K1) and the arrival of the reflected signal wich is registered by the receiver (K2) is effected by a counter (5) wich is connected by way of a gate circuit (4) to a free-running generator (3) which has a fixed frequency whose period duration is shorter than the shortest time to be expected between the application of the signal and the arrival of the reflected signal and longer than the largest admissible time increment in accordance with a required level of resolution for measurement of the time between the application of the signal and the arrival of the reflected signal,
the gate (4) is respectively opened in the time between the application of the signal to the measuring line and the arrival of the signal reflected at the end of the measuring line,
the counter (5) totals events produced by the generator (3) precisely when the gate (4) is opened,
the result of the counting operation is evaluated in the device (6) for evaluation of the counter results only when a number of gate openings is reached, after which there is a counter result with a predetermined degree of resolution,
the counter (5) is reset only when the result of the counting operation was read out, and
the result of the counting operation is converted in the device (6) for evaluation of the counter results into a measurement number for the material moisture content by means of a formula or an empirical table.

4. Apparatus for ascertaining material moisture content according to claim 1 or claim 2 characterised in that
measurement of the time between the application of the signal by the signal transmitter (K1) and the arrival of the reflected signal which is registered by the receiver (K2) is effected by a counter (5) which is connected by way of a gate circuit (4) to a free-running generator (3) which has a fixed frequency whose period duration is shorter than the shortest time to be expected between the application of a signal and the arrival of the reflected signal and longer than the greatest time increment which is still admissible in accordance with a required resolution for measurement of the time between the application of the signal and the arrival of the reflected signal,
the respective counter result is already recorded as a partial result in the device (6) for evaluation of the counter results after one or after so few gate openings, as a partial result, that a predetermined degree of resolution in respect of the counter result, which is required for the measurement result, is not yet reached, whereafter the counter is reset,
after recording of a predetermined number of partial results in the device (6) for evaluation of the counter results the mean value and variation are determined, and
a measurement number for the material moisture content is produced in the device (6) for evaluation of the counter results from the mean value by means of a formula or an empirical table and a number concerning the confidence interval thereof is produced from the variation.

5. Apparatus for ascertaining material moisture content according to one of claims 1 to 4 characterised in that
the measuring line (7a, 7b) comprises parallel bars.

6. Apparatus for ascertaining material moisture content according to one of claims 1 to 5 characterised in that
the conductors of the measuring line (7a, 7b) are provided with an insulating covering of constant dielectric constant.

7. Apparatus for ascertaining material moisture content according to one of claims 1 to 6 characterised in that
one of the conductors (7b) of the measuring line so encloses the other (7a) or others that external fields are screened.

8. Apparatus for ascertaining material moisture content according to one of claims 1 to 6 characterised in that
the conductors (7a, 7b) of the measuring line are such that they can lie on the surface of a sample with an almost flat surface so that the material moisture content can be measured in a solid sample, wherein for ascertaining by computation the material moisture content from the transit time of the reflected signal which is registered by the receiver (K2) account is taken of the fact that the dielectric is divided along the measuring line and there is a non-linear relationship between the transit time of the reflected signal.

9. Apparatus for ascertaining material moisture content according to one of claims 1 to 8 characterised in that
one of the conductors (7b) of the measuring line encloses the other (7a) or others in such a way that the edges of the enclosing conductor (7b) and the other conductor or conductors (7a) simultaneously lie on the surface of a flat sample so that measurement of the dielectric constant is not dependent on the region outside the enclosing conductor.

10. Apparatus for ascertaining material moisture content according to claim 9 characterised in that
the space between the enclosing conductor (7b) and the plane in which the apparatus lies on the sample is filled with a medium of a given dielectric constant.

11. Apparatus for ascertaining material moisture content according to one of claims 1 to 10 characterised in that
both the signal transmitter (K1) for applying the signal to the measuring line (7a, 7b) and also the receiver for registering the arrival of the reflected signal are respectively connected to the measuring line by way of lines (8) which are of such a length that the characteristic wave impedance at one end (9) is only little dependent on the termination at the other end (10) so that a matched termination in relation to the signal transmitter (K1) and to the time measuring circuit is made possible even in the case of a greatly different characteristic wave impedance of the measuring line itself, and
the time between the application of the signal by the signal transmitter (K1) to the measuring line (7a, 7b) and the arrival of the reflected signal which is registered by the receiver is measured at one end (9) of the measuring line by a gate circuit being opened when excitation by way of the series connection of the feed line from the signal transmitter (K1) to the measuring line and the connection between the measuring line and the time measuring circuit reaches the latter, and closed when the excitation which is reflected at the end of the measuring line reaches the time measuring circuit.

12. Apparatus for ascertaining material moisture content according to one of claims 1 to 11 characterised in that
there is provided a means which opens the gate circuit (4) only when any reflections at the beginning of the measuring line (7a, 7b) are over or after the excitation which arrives by way of a direct line has already arrived.

13. Apparatus for ascertaining material moisture content according to one of claims 1 to 12 characterised in that
there is provided a circuit which is connected as an adjustable impedance between the signal transmitter (K1) which has a low impedance and the measuring line (7a, 7b) whereby matching of the signal transmitter internal resistance to the characteristic wave impedance of the measuring line (7a, 7b), with the respective material moisture content, is effected in order to reduce distances due to reflection at the beginning of the measuring line (7a, 7b).

14. Apparatus for ascertaining material moisture content according to claim 13 characterised in that
there is provided a means which automatically adjusts the circuit for impedance matching in such a way that, with a measurement result which is recognised as false, the circuit for impedance matching is adjusted until a plausible result is reached which is inferred from the measurement result that is then reached to the characteristic wave impedance of the measuring line (7a, 7b) and the circuit for impedance matching is so adjusted that matching is reached and that thereafter a fresh measurement is made, the result of which serves to represent the material moisture content.

15. Apparatus for ascertaining material moisture content according to claim 13 or claim 14 characterised in that
the adjustment values necessary for matching purposes are taken from a table in which temperature is also taken into account.

16. Apparatus for ascertaining material moisture content according to one of claims 13 to 15 characterised in that
there is provided a computer with output circuits, by means of which computer the impedance matching means is automatically adjustable.

## Revendications

1. Dispositif pour déterminer l'humidité du matériau d'un milieu par détermination de la constante diélectrique de celui-ci, ledit milieu constituant le diélectrique d'une ligne de mesure (7a, 7b), à l'aide d'un émetteur de signaux (K1) qui injecte un signal en forme d'impulsion dans l'une des extrémités de la ligne de mesure (7a, 7b) et d'un récepteur (K2) qui reçoit à la même extrémité le signal réfléchi à l'autre extrémité de la ligne de mesure (7a, 7b), ainsi que d'un dispositif (3, 4, 5) destiné à mesurer le temps qui s'écoule entre le début de l'injection du signal et l'arrivée du signal réfléchi, caractérisé par le fait que la durée de l'impulsion du signal à injecter est supérieure au temps qui s'écoule entre le début de l'injection du signal et l'arrivée du signal réfléchi.

2. Dispositif pour déterminer l'humidité d'un matériau selon la revendication 1, caractérisé par le fait que la mesure du temps entre l'application du signal par l'émetteur de signaux (K1) et l'arrivée du signal réfléchi a lieu au moyen d'un dispositif (3, 4, 5) destiné à mesurer un temps par pas de progression, et par le fait que la résolution de la mesure, ainsi que la précision de la mesure, sont obtenues au moyen d'un dispositif (6) destiné à traiter les résultats des mesures par détermination automatique de la moyenne sur un grand nombre de mesures individuelles.

3. Dispositif pour déterminer l'humidité d'un matériau selon la revendication 1 ou 2, caractérisé par le fait que la mesure du temps entre l'application du signal par l'émetteur de signaux (K1) et l'arrivée du signal réfléchi qui est enregistré par le récepteur (K2) a lieu au moyen d'un compteur (5) relié par l'intermédiaire d'un circuit porte (4) à un générateur (3) à fonctionnement libre qui présente une fréquence fixe dont la période est inférieure à la plus faible durée prévisible entre l'application du signal et l'arrivée du signal réfléchi et supérieure au plus grand pas de progression dans le temps qui est acceptable pour obtenir une résolution exigée pour la mesure du temps entre l'application du signal et l'arrivée du signal réfléchi, par le fait que la porte (4) est à chaque fois ouverte dans le temps entre l'application du signal à la ligne de mesure et l'arrivée du signal qui est réfléchi à l'extrémité de la ligne de mesure, par le fait que le compteur (5) additionne des évènements engendrés par le générateur (3) au moment précis où la porte (4) est ouverte, par le fait que le résultat du processus de comptage n'est exploité dans le dispositif (6) destiné à exploiter les résultats du comptage que lorsque l'on atteint un nombre d'ouvertures de la porte après lequel on obtient un résultat de mesure présentant une résolution prédéterminée, par le fait que le compteur (5) n'est ramené à zéro que lorsque le résultat du processus de comptage a été lu, et par le fait que le résultat du processus de comptage est converti, dans le dispositif (6) destiné à exploiter les résultats du comptage, et à l'aide d'une formule ou d'une table empirique, en une valeur mesurée de l'humidité du matériau.

4. Dispositif pour déterminer l'humidité d'un matériau selon la revendication 1 ou 2, caractérisé par le fait que la mesure du temps entre l'application du signal par l'émetteur de signaux (K1) et l'arrivée du signal réfléchi qui est enregistré par le récepteur (K2) a lieu au moyen d'un compteur (5) relié par l'intermédiaire d'un circuit porte (4) à un générateur (3) à fonctionnement libre qui présente une fréquence fixe dont la période est inférieure à la plus faible durée prévisible entre l'application du signal et l'arrivée d'un signal réfléchi et supérieure au plus grand pas de progression dans le temps qui est encore acceptable pour obtenir une résolution exigée pour la mesure du temps entre l'application du signal et l'arrivée du signal réfléchi, par le fait que le résultat du comptage est déjà déterminé à chaque fois comme résultat partiel, dans le dispositif (6) destiné à exploiter les résultats du comptage, après une ouverture de porte ou après suffisamment peu d'ouvertures de porte pour qu'une résolution prédéterminée du résultat du comptage qui est nécessaire pour le résultat de la mesure ne soit pas encore atteinte, après quoi le compteur est ramené à zéro, par le fait qu'après avoir détecté un nombre prédéterminé de résultats partiels dans le dispositif (6) destiné à exploiter les résultats du comptage, on détermine la valeur moyenne et la dispersion, et par le fait que, dans le dispositif (6) destiné à exploiter les résultats du comptage, on engendre à partir de la valeur moyenne, et à l'aide d'une formule ou d'une table empirique, une valeur numérique mesurée de l'humidité du matériau, et, à partir de la dispersion, un nombre concernant l'intervalle de confiance de celle-ci.

5. Dispositif pour déterminer l'humidité d'un matériau selon l'une des revendications, 1 à 4, caractérisé par le fait que la ligne de mesure (7a, 7b) est constituée par des tiges parallèles.

6. Dispositif pour déterminer l'humidité d'un matériau selon l'une des revendications 1 à 5, caractérisé par le fait que les conducteurs de la ligne de mesure (7a, 7b) sont munis d'un revêtement isolant dont la constante diélectrique est constante.

7. Dispositif pour déterminer l'humidité d'un matériau selon l'une des revendications 1 à 6, caractérisé par le fait que l'un (7b) des conducteurs de la ligne de mesure entoure l'autre (7a) ou les autres d'une manière telle qu'il serve d'écran pour les champs situés à l'extérieur.

8. Dispositif pour déterminer l'humidité d'un matériau selon l'une des revendications 1 à 6, caractérisé par le fait que les conducteurs (7a, 7b) de la ligne de mesure sont constitués d'une manière telle qu'ils puissent reposer sur la surface d'un échantillon dont la surface est presque plane, de sorte que l'humidité du matériau peut être mesurée sur un échantillon solide, cependant qu'en vue de la détermination par le calcul de l'humidité du matériau à partir du temps de parcours du signal réfléchi qui est enregistré au moyen du récepteur (K2), on prend en considération le fait que le diélectrique est divisé le long de la ligne de mesure et qu'il existe une relation non linéaire avec le temps de parcours du signal réfléchi.

9. Dispositif pour déterminer l'humidité d'un matériau selon l'une des revendications 1 à 8, caractérisé par le fait que l'un (7b) des conducteurs de la ligne de mesure entoure l'autre (7a) ou les autres d'une manière telle que les bords du conducteur (7b) qui entoure l'autre, ainsi que l'autre conducteur (7a) ou les autres conducteurs, reposent simultanément sur la surface d'un échantillon plan, de sorte que la mesure de la constante diélectrique ne dépend pas de la zone située à l'extérieur du conducteur qui entoure l'autre.

10. Dispositif pour déterminer l'humidité d'un matériau selon la revendication 9, caractérisé par le fait que l'espace compris entre le conducteur (7b) qui entoure l'autre et le plan selon lequel le dispositif repose sur l'échantillon est rempli d'un milieu à constante diélectrique déterminée.

11. Dispositif pour déterminer l'humidité d'un matériau selon l'une des revendications 1 à 10, caractérisé par le fait que tant l'émetteur de signaux (K1) destiné à appliquer le signal à la ligne de mesure (7a, 7b) que le récepteur destiné à enregistrer l'arrivée du signal réfléchi sont à chaque fois reliés à la ligne de mesure par l'intermédiaire de conducteurs (8) qui sont assez longs pour que l'impédance caractéristique à une extrémité (9) ne dépende que peu du raccordement à l'autre extrémité (10), de sorte qu'un raccordement adapté à l'émetteur de signaux (K1) et au circuit de mesure du temps est rendu possible, même lorsque l'impédance caractéristique de la ligne de mesure elle-même est fortement différente, et par le fait que la durée entre l'application du signal à la ligne de mesure (7a, 7b) par l'émetteur de signaux (K1) et l'arrivée du signal réfléchi qui est enregistré au moyen du récepteur est mesurée à une extrémité (9) de la ligne de mesure, du fait qu'un circuit porte est ouvert lorsque l'excitation atteint le circuit de mesure du temps en passant par le conducteur d'amenée qui va de l'émetteur de signaux (K1) à la ligne de mesure et par la liaison entre la ligne de mesure et le circuit de mesure du temps qui est montée en série avec le conducteur d'amenée, et qu'il est fermé lorsque l'excitation réfléchie à l'extrémité de la ligne de mesure atteint le circuit de mesure du temps.

12. Dispositif pour déterminer l'humidité d'un matériau selon l'une des revendications 1 à 11, caractérisé par le fait qu'il est prévu un dispositif qui n'ouvre le circuit porte (4) que lorsque des réflexions éventuelles au début de la ligne de mesure (7a, 7b) sont terminées ou, respectivement, après que l'excitation qui arrive par l'intermédiaire de la ligne directe est déjà arrivée.

13. Dispositif pour déterminer l'humidité d'un matériau selon l'une des revendications 1 à 12, caractérisé par le fait qu'il est prévu un circuit qui est monté sous la forme d'une impédance réglable entre l'émetteur de signaux (K1), lequel est alors pourvu d'une impédance faible, et la ligne de mesure (7a, 7b), grâce à quoi on réalise une adaptation de la résistance interne de l'émetteur de signaux à l'impédance caractéristique de la ligne de mesure (7a, 7b) qui est présente pour chaque humidité du matériau, afin de diminuer les perturbations par réflexion au début de la ligne de mesure (7a, 7b).

14. Dispositif pour déterminer l'humidité d'un matériau selon la revendication 13, caractérisé par le fait qu'il est prévu un dispositif destiné à adapter automatiquement l'impédance d'une manière telle que, dans le cas d'un résultat de mesure qui est reconnu comme faux, le circuit destiné à adapter l'impédance est décalé jusqu'à ce que l'on atteigne un résultat plausible, que l'on déduit l'impédance caractéristique de la ligne de mesure (7a, 7b) du résultat de mesure qui a été obtenu alors, et que l'on règle le circuit destiné à adapter l'impédance d'une manière telle que l'adaptation soit atteinte, et par le fait qu'a lieu ensuite une nouvelle mesure dont le résultat sert à l'affichage de l'humidité du matériau.

15. Dispositif pour déterminer l'humidité d'un matériau selon la revendication 13 ou 14, caractérisé par le fait que les valeurs de réglage qui sont nécessaires pour l'adaptation sont extraites d'une table dans laquelle il est également tenu compte de la température.

16. Dispositif pour déterminer l'humidité d'un matériau selon l'une des revendications 13 à 15, caractérisé par le fait qu'il est prévu un calculateur qui est pourvu de circuits de sortie et au moyen duquel le dispositif destiné à adapter l'impédance peut être réglé automatiquement.
